# EUROPEAN PATENT APPLICATION

(11) **EP 4 495 611 A1**
(43) Date of publication of application: **22.01.2025**
(21) Application number: 23770189.1
(22) Date of filing: 10.02.2023
(51) Int. Cl.: G01R 31/327, B60L 3/00

(54) **POWER SOURCE DEVICE**

(30) Priority: 18.03.2022 JP 2022044336
(71) Applicant: Panasonic Energy Co., Ltd., Osaka 570-8511 (JP)
(72) Inventor: SUYAMA, Atsushi, Kadoma-shi, Osaka 571-0057 (JP); SAKAI, Atsushi, Kadoma-shi, Osaka 571-0057 (JP); MAEGAWA, Kazuya, Kadoma-shi, Osaka 571-0057 (JP)
(74) Representative: Novagraaf International SA
(86) International application number: PCT/JP2023/004568
(87) International publication number: WO 2023/176228

(57) **Abstract**

A power source device includes: a secondary battery; a discharging switch connected in series with the secondary battery; a current limiting switch that is connected in parallel with the discharging switch, and is switched to an on state to supply a limited current to a load in a pre-discharging period in which the discharging switch is in an off state; a current detection circuit that detects a current of the secondary battery; and a controlling circuit that controls the discharging switch and the current limiting switch to be turned on or off. The controlling circuit includes a failure diagnosis circuit for the discharging switch, and the failure diagnosis circuit compares a detection current of the secondary battery detected by the current detection circuit with a threshold set to a value larger than the limited current in the pre-discharging period, and when the detection current is larger than the threshold, determines that the discharging switch has an off impossible failure in which the discharging switch cannot be switched off.

## Description

### TECHNICAL FIELD

The present invention relates to a power source device in which a discharging switch is connected in series with a secondary battery, and particularly relates to a power source device including a circuit that determines failure in which the discharging switch cannot be switched off.

### BACKGROUND ART

The power source device in which the discharging switch is connected in series with the secondary battery can discharge the secondary battery while protecting the secondary battery by controlling the discharging switch by a remaining capacity of the secondary battery or the like. When an off impossible failure in which the discharging switch cannot be switched off occurs, the discharge current cannot be cut off. When the discharging switch has the off impossible failure, the remaining capacity of the secondary battery becomes the minimum remaining capacity, the discharge current cannot be cut off even if an off signal is input to the discharging switch, and adverse effects such as deterioration due to overdischarge of the secondary battery cannot be prevented. The off impossible failure of the discharging switch can be determined by detecting that the current is not cut off in a state where an off signal is input, but this method needs to stop power supply to the load. In order to solve this problem, a circuit configuration for determining a failure of a discharging switch without stopping power supply to the load has been developed. (See PTL 1)

### Citation List

### Patent Literature

PTL 1: Unexamined Japanese Patent Publication No. 2013-181822

### SUMMARY OF THE INVENTION

In the circuit that diagnoses an off impossible failure of a discharging switch disclosed in PTL 1, a switching element such as an FET having a parasitic diode is used for a charging switch and the discharging switch, or a switching element having no parasitic diode is connected to a diode corresponding to the parasitic diode in parallel, and the circuit controls one switching element to be set to an on state and the other switching element to be set to an off state without stopping a charging state or a discharging state of a battery, thereby determining an off impossible failure of the switching element. Since the switching element switched off flows current via the parasitic diode, one switching element can be brought into the off state to continue charging and discharging. A voltage drop of the switching element controlled to the off state is detected while charging or discharging is continued, and the off impossible failure is diagnosed. The switching element not having an off impossible failure that is switched to the off state flows current through the parasitic diode, and in this state, a voltage drop of about 0.6 V to 0.7 V occurs as a forward voltage. On the other hand, since the switching element having the off impossible failure is brought into a state of internal short circuit, the internal resistance is extremely low, and the voltage drop lower than the forward voltage of the diode occurs. Therefore, it is possible to detect that the voltage drop of the switching element controlled to the off state is lower than the forward voltage and determine the off impossible failure of the switching element.

Since the failure diagnosis circuit described above flows current, via the parasitic diode, the switching element controlled to the off state to detect the off impossible failure, it is necessary to connect the diode in parallel with the switching element. Since a load current flows through the diode at the time of failure diagnosis, there is an adverse effect such as an increase in heat generation due to Joule heat of the diode.

The present invention has been developed for the purpose of solving the above faults, and an important object of the present invention is to provide a power source device that can prevent adverse effects such as heat generation of a diode and detect an off impossible failure of a discharging switch.

A power source device according to an aspect of the present invention includes: a secondary battery; a discharging switch connected in series with the secondary battery; a current limiting switch that is connected in parallel with the discharging switch, and is switched to an on state to supply a limited current to a load in a pre-discharging period in which the discharging switch is in an off state; a current detection circuit that detects a current of the secondary battery; and a controlling circuit that causes the discharging switch and the current limiting switch to be turned on or off. The controlling circuit includes a failure diagnosis circuit for the discharging switch, and the failure diagnosis circuit compares a detection current of the secondary battery detected by the current detection circuit with a threshold set to a value larger than the limited current in the pre-discharging period, and when the detection current is larger than the threshold, determines the discharging switch has an off impossible failure in which the discharging switch cannot be switched off.

The power source device described above can prevent adverse effects such as heat generation of the diode and detect failure in which the discharging switch cannot be switched off.

### BRIEF DESCRIPTION OF THE DRAWINGS

Fig. 1 is a schematic block diagram of a power source device according to an exemplary embodiment of the present invention.
Fig. 2 is a diagram showing a change in current in a state where a discharging switch operates normally.
Fig. 3 is a diagram illustrating a change in current in a state where the discharging switch has an off impossible failure.

### DESCRIPTION OF EMBODIMENT

A power source device according to an aspect of the present invention includes: a secondary battery; a discharging switch connected in series with the secondary battery; a current limiting switch that is connected in parallel with the discharging switch, and is switched to an on state to supply a limited current to a load in a pre-discharging period in which the discharging switch is in an off state; a current detection circuit that detects a current of the secondary battery; and a controlling circuit that causes the discharging switch and the current limiting switch to be turned on or off, in which the controlling circuit includes a failure diagnosis circuit for the discharging switch, and the failure diagnosis circuit compares a detection current of the secondary battery detected by the current detection circuit with a threshold set to a value larger than the limited current in the pre-discharging period, and when the detection current is larger than the threshold, determines that the discharging switch has an off impossible failure in which the discharging switch cannot be switched off.

The power source device described above has a feature of being able to detect an off impossible failure in which the discharging switch cannot be switched off while preventing adverse effects such as heat generation of the diode. This is because, in a pre-discharging period in which the power source device described above brings the discharging switch into the off state, brings the current limiting switch into the on state, and supplies a load with the limited current, the power source device described above compares the detection current with the threshold set to a value larger than the limited current, and determines the off impossible failure in a state where the detection current is larger than the threshold.

According to the power source device described above, in a state where the discharging switch operates normally, the current flowing through the secondary battery is the limited current in the pre-discharging period. On the other hand, when the discharging switch has the off impossible failure due to an internal short circuit or the like, the state cannot be switched to the off state by an input signal even in the pre-discharging period, and the discharging switch is always retained in the on state with a small internal resistance. Therefore, it is possible to determine that the discharging switch has the off impossible failure by detecting a discharge current exceeding the threshold set to a value larger than the limited current in the pre-discharging period. According to the power source device described above, since it is possible to determine the off impossible failure of the discharging switch by comparing the discharge current with the threshold while controlling the timing of on and off of the discharging switch and the current limiting switch, it is possible to effectively determine the off impossible failure of the discharging switch while causing no adverse effect of Joule heat due to the load current flowing through the diode and connecting no diode unlike the conventional power source device.

A power source device according to another aspect of the present invention includes a charging switch that controls charging of a secondary battery, and charging switch can be controlled by a controlling circuit to control charging of the secondary battery.

In a power source device according to another aspect of the present invention, the controlling circuit includes a timing circuit, the timing circuit stores a pre-charging period in which charging switch is switched on to pre-charge the secondary battery, the pre-discharging period in which after the pre-charging period, the limited current is supplied to a load, and a discharging period in which after the pre-discharging period, the discharging switch is turned on to supply power to a load, and the failure diagnosis circuit performs failure diagnosis by connecting the secondary battery pre-charged in the pre-charging period to a load via the current limiting switch in the pre-discharging period.

Since, after pre-charging the secondary battery in the pre-charging period, the power source device described above supplies power to a load with the limited current in the pre-discharging period, it is possible to supply the limited current to the load in a state where the voltage of the secondary battery is an appropriate voltage by the pre-charge. The power source device described above can more reliably determine the failure of the discharging switch by providing a discharging period after the pre-discharging period and performing failure diagnosis.

In a power source device according to another aspect of the present invention, he failure diagnosis circuit repeats, a plurality of times, the pre-charging period, the pre-discharging period, and the discharging period, and determines a failure of the discharging switch by checking a state in which the detection current of the current detection circuit is larger than the threshold in a plurality of times of the pre-discharging periods.

The power source device described above can more reliably determine the failure of the discharging switch by repeating, a plurality of times, three steps including the pre-charging period, the pre-discharging period, and the discharging period and performing failure diagnosis in the plurality of times of pre-discharging periods.

A power source device according to another aspect of the present invention includes a charging and discharging switch connected in series with the secondary battery and controlled by the controlling circuit, in which the controlling circuit detects a failure of the discharging switch and switches off the charging and discharging switch.

Hereinafter, the present invention will be described in detail with reference to the drawings. Note that, in the following description, terms (e.g., "top/up/above/over", "bottom/down/below/under", and other terms including those terms) indicating specific directions or positions are used as necessary; however, the use of those terms is for facilitating the understanding of the invention with reference to the drawings, and the technical scope of the present invention is not limited by the meanings of the terms. Parts denoted by the same reference marks in a plurality of drawings indicate the same or equivalent parts or members.

Furthermore, an exemplary embodiment described below illustrates a specific example of the technical idea of the present invention, and the present invention is not limited to the exemplary embodiment below. Unless otherwise specified, dimensions, materials, shapes, relative arrangements, and the like of the configuration components described below are not intended to limit the scope of the present invention only to them, but are intended to be illustrative. The content described in one exemplary embodiment or example are also applicable to other exemplary embodiments and examples. The sizes, positional relationships, and the like of members illustrated in the drawings may be exaggerated in order to clarify description.

### (First exemplary embodiment)

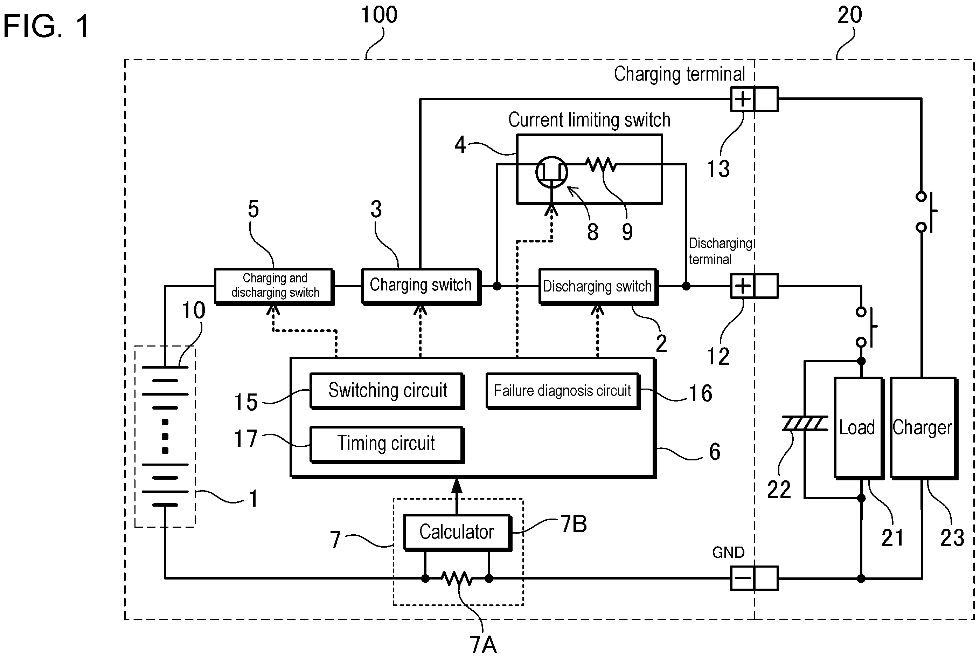

Power source device 100 of Fig. 1 includes secondary battery 1, discharging switch 2 connected in series with secondary battery 1, current limiting switch 4 connected in parallel with discharging switch 2, current detection circuit 7 that detects a current flowing through secondary battery 1, and controlling circuit 6 that controls discharging switch 2 and current limiting switch 4 to be turned on or off. Furthermore, power source device 100 in the drawing also includes charging switch 3 that is connected in series with secondary battery 1 and controls charging, and charging and discharging switch 5 that cuts off a charge and discharge current of secondary battery 1. Power source device 100 of Fig. 1 is provided with discharging terminal 12 and charging terminal 13, and a series circuit of charging and discharging switch 5, charging switch 3, and discharging switch 2 is connected between discharging terminal 12 and secondary battery 1. A series circuit of charging and discharging switch 5 and charging switch 3 is connected between charging terminal 13 and secondary battery 1.

### (Secondary battery 1)

In secondary battery 1, a plurality of battery cells 10 are connected in series, and the output voltage has a voltage optimum for the application. Furthermore, in secondary battery 1, the plurality of battery cells 10 are connected in parallel, and the capacity that allows charging and discharging and the maximum current that can be output have values suitable for the application.

### (Discharging switch 2, current limiting switch 4)

Discharging switch 2 is a semiconductor switching element such as an FET or a transistor that can be switched on or off by controlling circuit 6. However, as discharging switch 2, a switch such as a relay that mechanically switches a contact to an on state or off state can also be used. Current limiting switch 4 connects current limiting resistor 9 in series with switching element 8. Current limiting resistor 9 limits the current to be supplied to load 21 in the on state of switching element 8.

Discharging switch 2 is controlled to be turned on or off by controlling circuit 6 to control a discharge current that secondary battery 1 outputs to load 21. When discharging switch 2 is switched to the on state and power is supplied to load 21 connecting capacitor 22 having a large capacity (e.g., electrolytic capacitor) to the input side, a peak current flows and capacitor 22 is instantaneously charged at the moment when discharging switch 2 is switched to the on state. An excessive peak current causes adverse effects such as damage to discharging switch 2. In order to limit the excessive peak current, current limiting switch 4 is connected in parallel with discharging switch 2. Current limiting switch 4 is switched to the on state in the pre-discharging period in which discharging switch 2 is in the off state, and supplies a limited current to load 21. Power source device 100 in which current limiting switch 4 is connected in parallel with discharging switch 2 switches current limiting switch 4 to the on state while retaining discharging switch 2 in the off state, thereby limiting the current to be supplied to load 21. After capacitor 22 is charged with the limited current, discharging switch 2 is switched to the on state to supply power to load 21, whereby the peak current for charging capacitor 22 is limited, and discharging switch 2 can be smoothly switched to the on state.

Current limiting switch 4 can increase the electrical resistance of current limiting resistor 9 to reduce the peak current. For example, in power source device 100 in which current limiting resistor 9 is 10 Ω and the output voltage of secondary battery 1 is 400 V, the maximum value of the peak current is 40 A. Current limiting resistor 9 can increase the electrical resistance to reduce the maximum value of the peak current. However, when the electrical resistance of current limiting resistor 9 increases, the time for charging capacitor 22 increases. This is because the limited current decreases.

The electrical resistance of current limiting resistor 9 is set to, for example, 5 Ω to 20 Ω, preferably 6 Ω to 18 Ω, and more preferably 6 Ω to 15 Ω in consideration of the limited current and the charging time.

Since current limiting switch 4 is connected in parallel with discharging switch 2 in order to limit an excessive peak current flowing at the moment when discharging switch 2 is switched on, current limiting switch 4 is optimal for a power source for driving an electric vehicle such as a car, a motorcycle, a cart, or a bicycle. However, the present invention does not specify the application of the power source device to the power source of the electric vehicle, and can be used for all power source devices that instantaneously limit the peak current at the on timing of the discharging switch.

### (Current detection circuit 7)

Current detection circuit 7 detects a current flowing through secondary battery 1. Current detection circuit 7 illustrated in the drawing includes current detection resistor 7A connected in series to an output line of secondary battery 1 and calculator 7B that calculates a current value from a voltage at the both ends of current detection resistor 7A. Current detection circuit 7 detects the charge current and the discharge current while determining the charge current and the discharge current from the positive and negative of the detected current value.

### (Charging switch 3)

Charging switch 3 is switched to the on state in the charging period, and secondary battery 1 is charged by charger 23. When secondary battery 1 is fully charged, charging switch 3 is switched from an on state to an off state by a signal from controlling circuit 6, and charging of secondary battery 1 is stopped. Similarly to discharging switch 2, a semiconductor switching element such as an FET or a transistor is suitable as charging switch 3, but a switch such as a relay that mechanically switches a contact to an on state or off state can also be used.

In Fig. 1, charging switch 3 is configured to be disposed at a branch point between a charging path connecting secondary battery 1 to charger 23 and a discharging path connecting secondary battery 1 to load 21, and is not involved in opening and closing of the discharging path by a parasitic diode (or a diode connected in parallel) of the switching element of a body of charging switch 3. Therefore, even when charging switch 3 is in the off state, when discharging switch 2 is switched to the on state and current limiting switch 4 is switched to the on state, secondary battery 1 can be connected to load 21.

### (Charging and discharging switch 5)

As charging and discharging switch 5, all switches that are retained in the on state in a normal state and can be switched to the off state in an emergency can be used, but a switch that does not return to the on state after being switched to the off state is suitable. As charging and discharging switch 5, all switches that can be switched to the on state by controlling circuit 6 can be used, and thus, a fuse that can be fused by control from controlling circuit 6 can also be used.

### (Controlling circuit 6)

Controlling circuit 6 includes switching circuit 15 that switches on or off charging switch 3, discharging switch 2, current limiting switch 4, and charging and discharging switch 5, failure diagnosis circuit 16 for discharging switch 2, and timing circuit 17 that controls charging switch 3, discharging switch 2, and current limiting switch 4. Switching circuit 15 controls charging switch 3 and discharging switch 2 to prevent overcharge and overdischarge of secondary battery 1. In a state where discharging switch 2 is in the on state to discharge secondary battery 1, switching circuit 15 switches off discharging switch 2 to stop discharging when the remaining capacity decreases to a preset minimum capacity. Switching circuit 15 charges secondary battery 1 by bringing charging switch 3 into the on state when secondary battery 1 is discharged and the remaining capacity decreases, but in this state, when the remaining capacity of secondary battery 1 increases to the maximum capacity, charging switch 3 is switched off to stop charging. Switching circuit 15 detects the remaining capacity by the voltage of secondary battery 1 or calculates the remaining capacity by the integrated value of the charged and discharged current, thereby controlling charging switch 3 and discharging switch 2. Furthermore, upon detecting an abnormal state, switching circuit 15 switches charging and discharging switch 5 to the off state to cut off both the charge current and the discharge current of secondary battery 1.

Timing circuit 17 stores the pre-charging period in which both discharging switch 2 and current limiting switch 4 are brought into the off state, charging switch 3 is switched on, and secondary battery 1 is pre-charged, the pre-discharging period in which after the pre-charging period, a limited current is supplied to load 21, and the discharging period in which after the pre-charging period, discharging switch 2 is turned on and power is supplied to load 21. In the pre-charging period, both discharging switch 2 and current limiting switch 4 are retained in the off state, and charging switch 3 is switched on to temporarily charge secondary battery 1. In the pre-charging period, the voltage of secondary battery 1 is increased to an appropriate voltage, and power that can charge capacitor 22 on the input side of load 21 is charged. The pre-charging period can be lengthened to sufficiently charge secondary battery 1, but if the pre-charging period is too long, the timing of starting power supply to load 21 is delayed, and therefore, the pre-charging period is set to, for example, 0.51 sec to 3 sec. In the pre-discharging period, discharging switch 2 is retained in the off state, current limiting switch 4 is controlled to be turned on, and capacitor 22 connected to the input side of load 21 is charged with the limited current. The pre-discharging period can be lengthened to limit the peak current flowing at the moment when discharging switch 2 is switched from an off state to an on state, but if this period is also too long, the timing of starting power supply to load 21 is delayed, and therefore, the pre-charging period is set to, for example, 0.1 sec to 1 sec.

Controlling circuit 6 including timing circuit 17 described above pre-charges secondary battery 1 before supplying power to load 21, and then supplies power to load 21 with the limited current to charge capacitor 22 of load 21. Therefore, capacitor 22 can be quickly charged by secondary battery 1 having been pre-charged, and further, the voltage of secondary battery 1 can have an appropriate voltage by further pre-charging, whereby the limited current can be supplied to load 21. However, timing circuit 17 can limit the peak current of load 21 by bringing discharging switch 2 into the off state and switching current limiting switch 4 from an off state to an on state without necessarily pre-charging secondary battery 1.

Failure diagnosis circuit 16 uses current limiting switch 4 also for failure diagnosis of discharging switch 2. Failure diagnosis circuit 16 controls discharging switch 2 to be set to the off state, switches on current limiting switch 4, detects a value of the current supplied from secondary battery 1 to load 21, and diagnoses failure of discharging switch 2. Discharging switch 2 not having an off impossible failure does not connect secondary battery 1 to load 21 in the off state. In this state, when current limiting switch 4 is switched on, secondary battery 1 supplies a limited current to load 21 via current limiting switch 4. Discharging switch 2 having the off impossible failure of being not able to be switched due to the internal short circuit is not switched to the off state by the off signal from controlling circuit 6, and a short circuit formed by the internal short circuit connects secondary battery 1 to load 21. The current supplied from secondary battery 1 to load 21 by the short circuit is larger than the limited current supplied to load 21 via current limiting switch 4 in the on state. Therefore, failure diagnosis circuit 16 can switch on current limiting switch 4 in a state where discharging switch 2 is controlled to be set to the off state, and compare a value of the current supplied from secondary battery 1 to load 21 with a preset threshold, whereby the off impossible failure of discharging switch 2 can be determined. The threshold of the current for determining the off impossible failure is set to be larger than the limited current. Since the limited current slightly fluctuates depending on the voltage of secondary battery 1, the threshold of the failure diagnosis can be made larger than the maximum value of the limited current to reliably determine the failure of discharging switch 2.

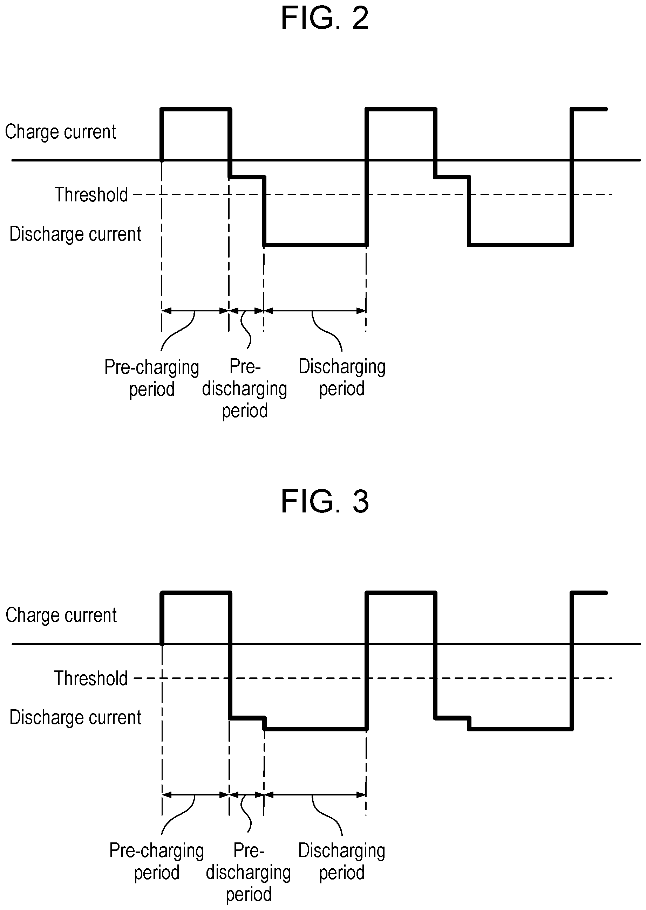

Figs. 2 and 3 show a change in current supplied from secondary battery 1 to load 21 by failure diagnosis circuit 16 controlling charging switch 3, current limiting switch 4, and discharging switch 2 to be turned on or off. In these drawings, the diagnosis timing at which the current is supplied from secondary battery 1 to load 21 to perform failure diagnose of discharging switch 2 is configured by three steps including the pre-charging period, the pre-discharging period, and the discharging period.

### [Pre-charging period]

In the pre-charging period, failure diagnosis circuit 16 controls both discharging switch 2 and current limiting switch 4 to be turned off, and controls charging switch 3 to be turned on. Charging switch 3 in the on state connects secondary battery 1 to charger 23 to charge secondary battery 1. In the pre-charging period, secondary battery 1 can be charged to a predetermined voltage value, and therefore the failure diagnosis of discharging switch 2 can be determined with high accuracy. It is possible to suppress a decrease in the remaining capacity due to discharge of secondary battery 1 at the diagnosis timing. The accuracy of the failure diagnosis of discharging switch 2 can be improved because the fluctuation of the discharge current due to the voltage fluctuation can be reduced by retaining the voltage of secondary battery 1 within a set range. In the method of diagnosing the failure of discharging switch 2 by comparing the discharge current of secondary battery 1 with a threshold, the accuracy of the failure diagnosis decreases when the discharge current fluctuates due to the voltage of secondary battery 1.

### [Pre-discharging period]

In the pre-discharging period, charging switch 3 and discharging switch 2 are controlled to the off state, and current limiting switch 4 is controlled to the on state. Current limiting switch 4 in the on state connects secondary battery 1 to load 21. Since discharging switch 2 switched normally to the off state does not connect secondary battery 1 to load 21, secondary battery 1 is connected to load 21 via current limiting switch 4, and a limited current flows through secondary battery 1. Discharging switch 2 having the off impossible failure is not switched to the off state by the off signal that is input, and secondary battery 1 and load 21 are connected by discharging switch 2 having the off impossible failure. Discharging switch 2 having the off impossible failure is internally short circuited and has a small internal resistance. In this state, secondary battery 1 is connected to load 21 by both discharging switch 2 and current limiting switch 4, but the internal resistance of discharging switch 2 having been internally short circuited is small, and the current is supplied from secondary battery 1 to load 21 via the failed electrical switch. Since the internal resistance of discharging switch 2 having the off impossible failure is smaller than the internal resistance of current limiting switch 4, more precisely, the electrical resistance of current limiting resistor 9 connected in series with the switching element, discharging switch 2 having the off impossible failure supplies a discharge current exceeding the limited current from secondary battery 1 to load 21. At this timing, failure diagnosis circuit 16 detects the discharge current of secondary battery 1, and compares the detection current with a threshold set to a value larger than the limited current, and in a state where the discharge current exceeds the threshold, diagnoses that discharging switch 2 has the off impossible failure.

Figs. 2 and 3 are graphs showing a value of a current flowing through secondary battery 1 by controlling charging switch 3, current limiting switch 4, and discharging switch 2 to be turned on or off by controlling circuit 6. Fig. 2 shows a change in current in a state in which discharging switch 2 operates normally, and Fig. 3 show a change in current in a state in which discharging switch 2 has the off impossible failure.

As shown in Fig. 2, in the state in which discharging switch 2 is operated normally by a control signal of an on or off signal to be input, a current flowing through secondary battery 1 is a limited current in the pre-discharging period. This is because, in the pre-discharging period, secondary battery 1 is connected to load 21 only via current limiting switch 4 with discharging switch 2 not connecting secondary battery 1 to load 21.

As shown in Fig. 3, discharging switch 2 having the off impossible failure due to an internal short or the like cannot be switched to the off state by the input signal, and is always retained in the on state with a small internal resistance. Therefore, in the pre-discharging period, discharging switch 2 having a small internal resistance connects secondary battery 1 to load 21, and a current exceeding the threshold is supplied from secondary battery 1 to load 21. Failure diagnosis circuit 16 repeats, a plurality of times, a failure diagnosis period including the pre-charging period, the pre-discharging period, and the discharging period, and determines that discharging switch 2 has the off impossible failure when the discharge current of secondary battery 1 exceeds the threshold in the pre-discharging period.

As described above, in the failure diagnosis period, secondary battery 1 is pre-charged by providing the pre-charging period in the preceding process of the pre-discharging period, and furthermore, the failure diagnosis is performed by repeating, a plurality of times, three steps including the pre-charging period, the pre-discharging period, and the discharging period, and yet furthermore, after the pre-discharging period in the failure diagnosis period, the failure diagnosis is performed by providing the discharging period, whereby the failure of discharging switch 2 can be determined more reliably. However, in the present invention, in the failure diagnosis period, it is possible to perform failure diagnose of discharging switch 2 only in the pre-discharging period without necessarily providing the pre-charging period and the discharging period, and it is also possible to diagnose the failure of discharging switch 2 without repeating the failure diagnosis period a plurality of times.

When failure diagnosis circuit 16 determines that discharging switch 2 has the off impossible failure, controlling circuit 6 performs error processing such as switching charging and discharging switch 5 from an on state to an off state or outputting an error signal to a side of device body 20 supplied with power from power source device 100. In error processing, various measures are taken to ensure safety for power source device 100 and device body 20.

In Figs. 2 and 3, the current value of secondary battery 1 in the pre-discharging period and the discharging period fluctuates depending on the internal resistance of discharging switch 2 having the off impossible failure, and further varies depending on the state of load 21. Since discharging switch 2 having the off impossible failure is mainly caused by an internal short circuit, discharging switch 2 having the off impossible failure is smaller in internal resistance than the on resistance of the semiconductor switching element that operates normally. Therefore, the internal resistance of discharging switch 2 having the off impossible failure is smaller than the electrical resistance of current limiting resistor 9 provided in current limiting switch 4. Therefore, when discharging switch 2 has the off impossible failure, the supply current from secondary battery 1 to load 21 in the pre-discharging period becomes larger than the limited current limited by current limiting resistor 9 and supplied to load 21. However, it is also considered that discharging switch 2 has the off impossible failure due to a failure other than internal short circuit, but even if it is assumed that the internal resistance of discharging switch 2 in the off impossible failure becomes larger than the internal short circuit state, the probability that the internal resistance of discharging switch 2 becomes larger than the electrical resistance of current limiting resistor 9 is extremely low. Therefore, failure diagnosis circuit 16 described above can reliably diagnose the off impossible failure of discharging switch 2.

### INDUSTRIAL APPLICABILITY

The power source device of the present invention is a power source device in which a discharging switch is connected in series with a secondary battery, and is particularly suitably used for a power source device that instantaneously limits a peak current at an on timing of the discharging switch, for example, a power supply that drives an electric vehicle such as a car, a motorcycle, a cart, or a bicycle.

### REFERENCE MARKS IN THE DRAWINGS

- 100: power source device

- 1: secondary battery
- 2: discharging switch
- 3: charging switch
- 4: current limiting switch
- 5: charging and discharging switch
- 6: controlling circuit
- 7: current detection circuit
- 7A: current detection resistor
- 7B: calculator
- 8: switching element
- 9: current limiting resistor
- 10: battery cell
- 12: discharging terminal
- 13: charging terminal
- 15: switching circuit
- 16: failure diagnosis circuit
- 17: timing circuit
- 20: device body
- 21: load
- 22: capacitor
- 23: charger

## Claims

1. A power source device comprising:
a secondary battery;
a discharging switch connected in series with the secondary battery;
a current limiting switch that is connected in parallel with the discharging switch, and is switched to an on state to supply a limited current to a load in a pre-discharging period in which the discharging switch is in an off state;
a current detection circuit that detects a current of the secondary battery; and
a controlling circuit that causes the discharging switch and the current limiting switch to be turned on or off,
wherein
the controlling circuit includes a failure diagnosis circuit for the discharging switch, and
the failure diagnosis circuit compares
a detection current of the secondary battery detected by the current detection circuit with a threshold set to a value larger than the limited current in the pre-discharging period, and
when the detection current is larger than the threshold, determines that the discharging switch has an off impossible failure in which the discharging switch cannot be switched off.

2. The power source device according to Claim 1, further comprising a charging switch that controls charging of the secondary battery,
wherein the charging switch is controlled by the controlling circuit to control charging of the secondary battery.

3. The power source device according to Claim 2, wherein
the controlling circuit includes a timing circuit,
the timing circuit stores
a pre-charging period in which charging switch is switched on to pre-charge the secondary battery,
the pre-discharging period in which after the pre-charging period, the limited current is supplied to a load, and
a discharging period in which after the pre-discharging period, the discharging switch is turned on to supply power to a load, and
the failure diagnosis circuit performs failure diagnosis by connecting the secondary battery pre-charged in the pre-charging period to a load via the current limiting switch in the pre-discharging period.

4. The power source device according to Claim 3, wherein
the failure diagnosis circuit
repeats, a plurality of times, the pre-charging period, the pre-discharging period, and the discharging period, and
determines a failure of the discharging switch by checking a state in which the detection current of the current detection circuit is larger than the threshold in a plurality of times of the pre-discharging periods.

5. The power source device according to any one of Claims 1 to 4, further comprising a charging and discharging switch connected in series with the secondary battery and controlled by the controlling circuit,
wherein the controlling circuit detects a failure of the discharging switch and switches off the charging and discharging switch.
